(19)

Europäisches
Patentamt
European
Patent Office
Office européen
des brevets

(11) **EP 3 079 155 A1**

(12) **EUROPEAN PATENT APPLICATION**
published in accordance with Art. 153(4) EPC

(43) Date of publication:
**12.10.2016 Bulletin 2016/41**

(21) Application number: **14867183.7**

(22) Date of filing: **04.12.2014**

(51) Int Cl.:
**H01B 1/24** *(2006.01)*          **H01B 1/04** *(2006.01)*
**H05K 9/00** *(2006.01)*

(86) International application number:
**PCT/KR2014/011814**

(87) International publication number:
**WO 2015/084067 (11.06.2015 Gazette 2015/23)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **06.12.2013   KR 20130151488**

(71) Applicant: **LG Chem, Ltd.**
**Seoul 150-721 (KR)**

(72) Inventors:
• **CHOI, Yeon sik**
  **Daejeon 305-738 (KR)**
• **LEE, Su Min**
  **Daejeon 305-738 (KR)**
• **CHOI, Gi Dae**
  **Daejeon 305-738 (KR)**
• **YUN, ChangHun**
  **Daejeon 305-738 (KR)**

(74) Representative: **Goddar, Heinz J.**
**Boehmert & Boehmert**
**Anwaltspartnerschaft mbB**
**Patentanwälte Rechtsanwälte**
**Pettenkoferstrasse 20-22**
**80336 München (DE)**

(54) **COMPOSITE MATERIAL HAVING IMPROVED ELECTRICAL CONDUCTIVITY AND MOLDED PART CONTAINING SAME**

(57)     Provided is a composite produced by processing a resin composition including a thermoplastic resin, carbon nanotubes, and a carbonaceous conductive additive. The carbon nanotubes have an $I_D/I_G$ of 1.0 or less before the processing. The ratio of residual length of the carbon nanotubes present in the composite is from 40% to 99%. The composite has improved conductivity without deterioration of mechanical properties. Due to these advantages, the composite can be used to manufacture various molded articles.

**Description**

BACKGROUND OF THE INVENTION

1. Field of the Invention

The present invention relates to a composite with improved conductivity and a molded article including the same.

2. Description of the Related Art

Thermoplastic resins, particularly high performance plastics with excellent mechanical properties and good heat resistance, are used in various applications. For example, polyamide resins and polyester resins are suitable for use in the manufacture of a variety of industrial parts, including electrical/electronic parts, machine parts and automotive parts, mainly by injection molding due to their good balance of mechanical properties and toughness. Polyester resins, particularly polybutylene terephthalate and polyethylene terephthalate, with excellent in moldability, heat resistance, mechanical properties, and chemical resistance are widely used as materials for industrial molded articles such as connectors, relays, and switches of automobiles and electrical/electronic devices. Amorphous resins such as polycarbonate resins are highly transparent and dimensionally stable. Due to these advantages, amorphous resins are used in many fields, including optical materials and parts of electric appliances, OA equipment, and automobiles.

Electrical/electronic parts should be prevented from malfunction caused by static electricity and contamination by dirt. For this purpose, electrical/electronic parts are required to have antistatic properties. Automobile fuel pump parts are also required to have high electrical conductivity in addition to existing physical properties.

Additives such as surfactants, metal powders and metal fibers are generally used to impart electrical conductivity to resins. However, these additives tend to deteriorate the physical properties (such as conductivity and mechanical strength) of final molded articles.

Conductive carbon black is a common material for imparting conductivity to resins. However, the addition of a large amount of carbon black is necessary to achieve high electrical conductivity and the structure of carbon black also tends to decompose during melt mixing. The resulting resins suffer from poor processability and considerable deterioration in thermal stability and other physical properties.

Under these circumstances, the research has been concentrated on resin composites including carbon nanotubes instead of conductive carbon black in order to achieve improved conductivity while reducing the use of conductive fillers.

SUMMARY OF THE INVENTION

It is an object of the present invention to provide a composite with improved conductivity.

It is a further object of the present invention to provide a molded article that has improved conductivity without losing its mechanical strength.

According to one aspect of the present invention, there is provided a composite produced by processing a resin composition including a thermoplastic resin, bundle type carbon nanotubes, and a carbonaceous conductive additive wherein the carbon nanotubes have an $I_D/I_G$ of 1.0 or less before the processing and the average length of the carbon nanotubes present in the composite after the processing is from 40% to 99% with respect to the average length of the carbon nanotubes before the processing, the $I_D/I_G$ representing the ratio of the intensity of D peak to that of G peak in the Raman spectrum of the carbon nanotubes.

According to a further aspect of the present invention, there is provided a molded article including the composite.

The composite according to one aspect of the present invention is produced by extrusion of a thermoplastic resin composition including carbon nanotubes and a carbonaceous conductive additive. The carbon nanotubes as raw materials have a low $I_D/I_G$, indicating that they undergo less decomposition during extrusion. As a result, the carbon nanotubes present in the composite as the final product are less reduced in average length, resulting in an improvement in the conductivity of the composite while minimizing changes in the physical properties of the thermoplastic resin. In addition, the addition of the carbonaceous conductive additive contributes to a further improvement in conductivity. Therefore, the composite is suitable for use in various parts where high conductivity is required.

DETAILED DESCRIPTION OF THE INVENTION

The present invention will now be described in detail. It should be pointed out that the terminologies and words used in this specification and claims should not be interpreted as being limited to usual or lexical meaning, but should be interpreted as meanings and concepts corresponding to the technical ideas of the present invention based on the principle that the inventor can properly define the concepts of the terminologies to describe best his own invention.

One aspect of the present invention provides a composite produced by processing a resin composition including a thermoplastic resin, bundle type carbon nanotubes, and a carbonaceous conductive additive wherein the carbon nanotubes have an $I_D/I_G$ of 1.0 or less before the processing and a ratio of residual length of 40% to 99% after the processing.

The ratio of residual length can be defined by Equation 1:

$$\text{Ratio of residual length (\%) = (Average length of the carbon}$$
$$\text{nanotubes present in the composite after processing/Average length of the}$$
$$\text{carbon nanotubes as raw materials before processing)} \times 100 \quad (1)$$

The $I_D/I_G$ represents the ratio of the intensity of D peak (D band) to the intensity of G peak (G band) in the Raman spectrum of the carbon nanotubes before the processing. Generally, the Raman spectrum of carbon nanotubes has two major distinguishable peaks corresponding to graphitic $sp^2$ bonds, that is, a higher peak at 1,100 to 1,400 $cm^{-1}$ and a lower peak at 1,500 to 1,700 $cm^{-1}$. The first peak (D-band) centered at around 1,300 $cm^{-1}$, for example, around 1,350 $cm^{-1}$, is indicative of the presence of carbon particles and reflects the characteristics of incomplete and disordered walls. The second peak (G-band) centered at around 1,600 $cm^{-1}$, for example, 1580 $cm^{-1}$, is indicative of the formation of continuous carbon-carbon (C-C) bonds and reflects the characteristics of crystalline graphite layers of carbon nanotubes. The wavelength values may slightly vary depending on the wavelength of a laser used for spectral measurement.

The degree of disorder or defectiveness of the carbon nanotubes can be evaluated by the intensity ratio of D-band peak to G-band peak ($I_D/I_G$). As the ratio $I_D/I_G$ increases, the carbon nanotubes can be evaluated to be highly disordered or defective. As the ratio $I_D/I_G$ decreases, the carbon nanotubes can be evaluated to have few defects and a high degree of crystallinity. The term "defects" used herein is intended to include imperfections, for example, lattice defects, in the arrangement of the carbon nanotubes formed when unnecessary atoms as impurities enter the constituent carbon-carbon bonds of the carbon nanotubes, the number of necessary carbon atoms is insufficient, or misalignment occurs. The carbon nanotubes are easily cut at the defective portions when external stimuli are applied thereto.

Each of the intensities of D-band peak and G-band peak may be, for example, defined as either the height of the peak above the X-axis center of the band or the area under the peak in the Raman spectrum. The height of the peak above the X-axis center of the corresponding band may be adopted for ease of measurement.

According to one embodiment, the $I_D/I_G$ of the carbon nanotubes as raw materials before the processing may be limited to 1.0 or less, for example, the range of 0.01 to 0.99. Within this range, the average length of the carbon nanotubes present in the composite as the final product after the processing can be less reduced. The ratio of residual average length of the carbon nanotubes can be represented by the above equation 1.

The higher the ratio of residual length, the smaller the consumption of the carbon nanotubes to increase the conductivity of the thermoplastic resin, which is advantageous in maintaining the physical properties of the resin.

In the present invention, the $I_D/I_G$ value of the carbon nanotubes as raw materials added to the thermoplastic resin before processing is limited to the range defined above. By selective use of the carbon nanotubes with few defects and a high degree of crystallinity, it is possible that a reduced amount of the carbon nanotubes is cut during processing such as extrusion. A reduction in the amount of the carbon nanotubes cut by external stimuli during processing leads to an increase in the ratio of residual length of the carbon nanotubes after processing.

The carbon nanotubes with an increased ratio of residual length are structurally advantageous in improving the conductivity of the thermoplastic resin. The carbon nanotubes have network structures within a matrix of the thermoplastic resin. Accordingly, the longer carbon nanotubes remaining in the final product are more advantageous in the formation of the networks, and as a result, the frequency of contact between the networks decreases. This leads to a reduction in contact resistance, contributing to a further improvement in conductivity.

According to one embodiment, the ratio of residual length of the carbon nanotubes may be in the range of 40% to 99%, for example, 40% to 90%. Within this range, the conductivity of the composite as the final product can be improved while maintaining the processability of the composite without deterioration of mechanical properties.

Carbon nanotubes (CNTs) are tubular materials consisting of carbon atoms arranged in a hexagonal pattern and have a diameter of approximately 1 to 100 nm. Carbon nanotubes exhibit insulating, conducting or semiconducting properties depending on their inherent chirality. Carbon nanotubes have a structure in which carbon atoms are strongly covalently bonded to each other. Due to this structure, carbon nanotubes have a tensile strength approximately 100 times that of steel, are highly flexible and elastic, and are chemically stable.

Carbon nanotubes are divided into three types: single-walled carbon nanotubes (SWCNTs) consisting of a single sheet and having a diameter of about 1 nm; double-walled carbon nanotubes (DWCNTs) consisting of two sheets and having a diameter of about 1.4 to about 3 nm; and multi-walled carbon nanotubes (MWCNTs) consisting of three or more sheets and having a diameter of about 5 to about 100 nm. All types of carbon nanotubes may be used without particular limitation in the resin composition.

Unless otherwise mentioned, the term "bundle type carbon nanotubes" used herein refers to a type of carbon nanotubes in which the carbon nanotubes are arranged in parallel or get entangled to form bundles or ropes, and the term "non-bundle or entangled type carbon nanotubes" describes a type of carbon nanotubes that does not have a specific shape such as a bundle- or rope-like shape.

The bundle type carbon nanotubes basically have a shape in which carbon nanotube strands are joined together to form bundles. These strands may have a straight or curved shape or a combination thereof. The bundle type carbon nanotubes may also have a linear or curved shape or a combination thereof. According to one embodiment, the bundle type carbon nanotubes may have a thickness of 50 nm to 100 $\mu$m.

According to one embodiment, the carbon nanotube strands may be, for example, from 5 nm to 25 nm in average diameter.

According to one embodiment, the bundle type carbon nanotubes may have an average length of approximately 1 $\mu$m or more, for example, in the range of $10^3$ to $10^6$ nm. Within this range, the bundle type carbon nanotubes are structurally advantageous in improving the conductivity of the thermoplastic resin composite. The carbon nanotubes have network structures within a matrix of the thermoplastic resin composite. Accordingly, the longer carbon nanotubes are more advantageous in the formation of the networks, and as a result, the frequency of contact between the networks decreases. This leads to a reduction in contact resistance, contributing to a further improvement in conductivity.

According to one embodiment, the carbon nanotubes used in the thermoplastic resin composite may have a relatively high bulk density in the range of 80 to 250 kg/m$^3$, for example, 100 to 220 kg/m$^3$. Within this range, the conductivity of the composite can be advantageously improved.

According to one embodiment, the carbon nanotubes present in the thermoplastic resin composite after processing may be from 400 to 100,000 nm, from 500 to 30,000 nm or from 500 to 5,000 nm in length.

The term "bulk density" used herein means the apparent density of the carbon nanotubes as raw materials and can be calculated by dividing the weight of the carbon nanotubes by the volume of the carbon nanotubes.

According to one embodiment, the bundle type carbon nanotubes may be used in an amount of 0.1 to 10 parts by weight or 0.1 to 5 parts by weight, based on 100 parts by weight of the thermoplastic resin. Within this range, the conductivity of the composite can be sufficiently improved while maintaining the mechanical properties of the composite.

According to one embodiment, the conductivity of the resin composition is improved by addition of the carbon nanotubes to the thermoplastic resin. At this time, deterioration of the mechanical properties inherent to the thermoplastic resin needs to be minimized. Further, problems such as void formation should not be caused during processing of the composition into the composite or processing of the composite into a molded article. Thus, the carbonaceous conductive additive, together with the carbon nanotubes with the above-described characteristics, is used in the resin composition to improve further the conductivity of the composite while maintaining the processability of the composite.

According to one embodiment, the carbonaceous conductive additive may be selected from, for example, carbon black, graphene, carbon nanofibers, fullerenes, and carbon nanowires. The carbonaceous conductive additive may be added in an amount ranging from about 0.1 to about 30 parts by weight or from 0.1 to 10 parts by weight, based on 100 parts by weight of the thermoplastic resin. Within this range, the conductivity of the resin composition can be further improved without a deterioration in the physical properties of the resin composition.

The carbonaceous conductive additive may be carbon black. As the carbon black, there may be used, for example, furnace black, channel black, acetylene black, lamp black, thermal black or ketjen black. However, the kind of the carbon black is not limited. The carbon black may have an average particle diameter in the range of 20 to 100 $\mu$m. Within this range, the conductivity of the resin composition can be efficiently improved.

The carbonaceous conductive additive may be graphene. Graphene, a two-dimensional carbon allotrope, can be produced by various methods, such as exfoliation, chemical oxidation/reduction, thermolysis, and chemical vapor deposition. The exfoliation refers to a method in which a single layer of graphene is physically separated from graphite, the chemical oxidation/reduction refers to a method in which graphite is dispersed in a solution and is chemically reduced to obtain graphene, and the thermolysis refers to a method in which a silicon carbide (SiC) substrate is thermally decomposed at a high temperature to obtain a graphene layer. Particularly, an exemplary method for synthesizing high-quality graphene is chemical vapor deposition.

According to one embodiment, the graphene may have an aspect ratio of 0.1 or less, consist of 100 layers or less, and have a specific surface area of 300 m$^2$/g or more. The graphene refers to a single planar network of sp$^2$-bonded carbon (C) atoms in the hcp crystal structure of graphite. In a broad sense, graphene is intended to include graphene composite layers consisting of a plurality of layers.

According to one embodiment, the carbonaceous conductive additive may be a carbon nanofiber with large specific surface area, high electrical conductivity, and good adsorbability. For example, the carbon nanofiber may be produced by decomposing a carbon-containing gaseous compound at a high temperature, growing the decomposition products, and further growing the resulting carbon materials in the form of a fiber on a previously prepared metal catalyst. The decomposed carbon products are subjected to adsorption, decomposition, absorption, diffusion, and deposition on the surface of the metal catalyst having a size of several nanometers to form a laminate of graphene layers with high crystallinity and purity. The metal catalyst may be a transition metal such as nickel, iron or cobalt and may be in the form of particles. The carbon nanofiber formed on the catalyst particles grow to a diameter in the nanometer range, which corresponds to about one-hundredth of the diameters (-10 μm) of other kinds of general purpose carbon fibers. The small diameter allows the carbon nanofiber to have large specific surface area, high electrical conductivity, good adsorbability, and excellent mechanical properties. Due to these advantages, the carbon nanofiber is suitable for use in the resin composition.

The carbon nanofiber can be synthesized by various methods, including arc discharge, laser ablation, plasma chemical vapor deposition, and chemical vapor deposition (CVD). The growth of the carbon nanofiber is influenced by such factors as temperature and the kinds of carbon source, catalyst, and substrate used. Particularly, diffusion of the catalyst particles and the substrate and a difference in interfacial interaction therebetween affect the shape and microstructure of the synthesized carbon nanofiber.

According to one embodiment, the thermoplastic resin composite may further include one or more additives selected from the group consisting of flame retardants, impact modifiers, flame retardant aids, lubricants, plasticizers, heat stabilizers, anti-drip agents, antioxidants, compatibilizers, light stabilizers, pigments, dyes, and inorganic additives. The additives may be used in an amount of 0.1 to 10 parts by weight or 0.1 to 5 parts by weight, based on 100 parts by weight of the thermoplastic resin. Specific kinds of these additives are well known in the art and may be appropriately selected by those skilled in the art.

The thermoplastic resin used in the production of the composite may be any of those known in the art. According to one embodiment, the thermoplastic resin may be selected from the group consisting of: polycarbonate resins; polypropylene resins; polyamide resins; aramid resins; aromatic polyester resins; polyolefin resins; polyester carbonate resins; polyphenylene ether resins; polyphenylene sulfide resins; polysulfone resins; polyethersulfone resins; polyarylene resins; cycloolefin resins; polyetherimide resins; polyacetal resins; polyvinyl acetal resins; polyketone resins; polyether ketone resins; polyether ether ketone resins; polyaryl ketone resins; polyether nitrile resins; liquid crystal resins; polybenzimidazole resins; polyparabanic acid resins; vinyl polymer and copolymer resins obtained by polymerization or copolymerization of one or more vinyl monomers selected from the group consisting of aromatic alkenyl compounds, methacrylic esters, acrylic esters, and vinyl cyanide compounds; diene-aromatic alkenyl compound copolymer resins; vinyl cyanide-diene-aromatic alkenyl compound copolymer resins; aromatic alkenyl compound-diene-vinyl cyanide-N-phenylmaleimide copolymer resins; vinyl cyanide-(ethylene-diene-propylene (EPDM))-aromatic alkenyl compound copolymer resins; polyolefins; vinyl chloride resins; chlorinated vinyl chloride resins; and mixtures thereof. Specific kinds of these resins are well known in the art and may be appropriately selected by those skilled in the art.

Examples of the polyolefin resins include, but are not limited to, polypropylene, polyethylene, polybutylene, and poly(4-methyl-1-pentene). These polyolefin resins may be used alone or in combination thereof. In one embodiment, the polyolefins are selected from the group consisting of polypropylene homopolymers (e.g., atactic polypropylene, isotactic polypropylene, and syndiotactic polypropylene), polypropylene copolymers (e.g., polypropylene random copolymers), and mixtures thereof. Suitable polypropylene copolymers include, but are not limited to, random copolymers prepared by polymerization of propylene in the presence of at least one comonomer selected from the group consisting of ethylene, but-1-ene (i.e. 1-butene), and hex-1-ene (i.e. 1-hexene). In the polypropylene random copolymers, the comonomer may be present in any suitable amount but is present typically in an amount of about 10% by weight or less (for example, about 1 to about 7% by weight or about 1 to about 4.5% by weight).

The polyester resins may be homopolyesters or copolyesters as polycondensates of dicarboxylic acid component and diol component skeletons. Representative examples of the homopolyesters include polyethylene terephthalate, polypropylene terephthalate, polybutylene terephthalate, polyethylene-2,6-naphthalate, poly-1,4-cyclohexanedimethylene terephthalate, and polyethylene diphenylate. Particularly preferred is polyethylene terephthalate that can be used in many applications due to its low price. The copolyesters are defined as polycondensates of at least three components selected from the group consisting of components having a dicarboxylic acid skeleton and components having a diol skeleton. Examples of the components having a dicarboxylic acid skeleton include terephthalic acid, isophthalic acid, phthalic acid, 1,4-naphthalene dicarboxylic acid, 1,5-naphthalene dicarboxylic acid, 2,6-naphthalene dicarboxylic acid, 4,4'-diphenyldicarboxylic acid, 4,4'-diphenylsulfone dicarboxylic acid, adipic acid, sebacic acid, dimer acid, cyclohexane dicarboxylic acid, and ester derivatives thereof. Examples of the components having a diol skeleton include ethylene glycol, 1,2-propanediol, 1,3-butanediol, 1,4-butanediol, 1,5-pentanediol, diethylene glycol, polyalkylene glycol, 2,2-bis(4'-β-hydroxyethoxyphenyl)propane, isosorbates, 1,4-cyclohexanedimethanol, and spiroglycols.

Examples of the polyamide resins include nylon resins and nylon copolymer resins. These polyamide resins may be used alone or as a mixture thereof. The nylon resins may be: polyamide-6 (nylon 6) obtained by ring-opening polymerization of commonly known lactams such as ε-caprolactam and w-dodecalactam; nylon polymerization products obtainable from amino acids such as aminocaproic acid, 11-aminoundecanoic acid, and 12-aminododecanoic acid; nylon polymers obtainable by polymerization of an aliphatic, alicyclic or aromatic diamine, such as ethylenediamine, tetramethylenediamine, hexamethylenediamine, undecamethylenediamine, dodecamethylenediamine, 2,2,4-trimethylhexamethylenediamine, 2,4,4-trimethylhexamethylenediamine, 5-methylnonahexamethylenediamine, meta-xylenediamine, para-xylenediamine, 1,3-bisaminomethylcyclohexane, 1,4-bisaminomethylcyclohexane, 1-amino-3-aminomethyl-3,5,5-trimethylcyclohexane, bis(4-aminocyclohexane)methane, bis(4-methyl-4-aminocyclohexyl)methane, 2,2-bis(4-aminocyclohexyl)propane, bis(aminopropyl)piperazine or aminoethylpiperidine, with an aliphatic, alicyclic or aromatic dicarboxylic acid, such as adipic acid, sebacic acid, azelaic acid, terephthalic acid, 2-chloroterephthalic acid or 2-methylterephthalic acid; and copolymers and mixtures thereof. Examples of the nylon copolymers include: copolymers of polycaprolactam (nylon 6) and polyhexamethylene sebacamide (nylon 6,10); copolymers of polycaprolactam (nylon 6) and polyhexamethylene adipamide (nylon 66); and copolymers of polycaprolactam (nylon 6) and polylauryllactam (nylon 12).

The polycarbonate resins may be prepared by reacting a diphenol with phosgene, a haloformate, a carbonate or a combination thereof. Specific examples of such diphenols include hydroquinone, resorcinol, 4,4'-dihydroxydiphenyl, 2,2-bis(4-hydroxyphenyl)propane (also called 'bisphenol-A'), 2,4-bis(4-hydroxyphenyl)-2-methylbutane, bis(4-hydroxyphenyl)methane, 1,1-bis(4-hydroxyphenyl)cyclohexane, 2,2-bis(3-chloro-4-hydroxyphenyl)propane, 2,2-bis(3,5-dimethyl-4-hydroxyphenyl)propane, 2,2-bis(3,5-dichloro-4-hydroxyphenyl)propane, 2,2-bis(3,5-dibromo-4-hydroxyphenyl)propane, bis(4-hydroxyphenyl)sulfoxide, bis(4-hydroxyphenyl)ketone; and bis(4-hydroxyphenyl)ether. Of these, 2,2-bis(4-hydroxyphenyl)propane, 2,2-bis(3,5-dichloro-4-hydroxyphenyl)propane or 1,1-bis(4-hydroxyphenyl)cyclohexane is preferred, and 2,2-bis(4-hydroxyphenyl)propane is more preferred.

The polycarbonate resins may be mixtures of copolymers prepared from two or more different diphenols. As the polycarbonate resins, there may be used, for example, linear polycarbonate resins, branched polycarbonate resins, and polyester carbonate copolymer resins.

The linear polycarbonate resins may be, for example, bisphenol-A type polycarbonate resins. The branched polycarbonate resins may be, for example, those prepared by reacting a polyfunctional aromatic compound, such as trimellitic anhydride or trimellitic acid, with a diphenol and a carbonate. The polyfunctional aromatic compound may be included in an amount of 0.05 to 2 mole %, based on the total moles of the corresponding branched polycarbonate resin. The polyester carbonate copolymer resins may be, for example, those prepared by reacting a difunctional carboxylic acid with a diphenol and a carbonate. As the carbonate, there may be used, for example, a diaryl carbonate, such as diphenyl carbonate, or ethylene carbonate.

As the cycloolefin polymers, there may be exemplified norbornene polymers, monocyclic olefin polymers, cyclic conjugated diene polymers, vinyl alicyclic hydrocarbon polymers, and hydrides thereof. Specific examples of the cycloolefin polymers include ethylene-cycloolefin copolymers available under the trade name "Apel" (Mitsui Chemicals), norbornene polymers available under the trade name "Aton" (JSR), and norbornene polymers available under the trade name "Zeonoa" (Nippon Zeon).

Another aspect of the present invention provides a method for producing the thermoplastic resin composite. The method is not particularly limited. For example, the thermoplastic resin composite may be produced by feeding a mixture of the raw materials into a generally known melt-mixer such as a single-screw extruder, a twin-screw extruder, a Banbury mixer, a kneader or a mixing roll, and kneading the mixture at a temperature of approximately 100 to 500 °C or 200 to 400 °C.

The mixing order of the raw materials is not particularly limited. For example, the thermoplastic resin, the carbon nanotubes having an average length in the range defined above, and optionally the additives are pre-blended, and the blend is homogeneously melt kneaded using a single- or twin-screw extruder at or above the melting point of the thermoplastic resin. Alternatively, the raw materials are mixed in a solution and the solvent is removed. Taking into consideration productivity, it is preferred to homogeneously melt knead the raw materials using a single- or twin-screw extruder. It is particularly preferred to use a twin-screw extruder when the raw materials are homogeneously melt kneaded at or above the melting point of the thermoplastic resin.

Any kneading method may be used to produce the composite of the present invention. For example, the thermoplastic resin and the carbon nanotubes may be kneaded together at one time. According to a master pellet method, a resin composition (master pellets) including the carbon nanotubes at a high concentration in the thermoplastic resin is prepared, the carbon nanotubes are further added to the resin composition until the concentration reaches a specified level, followed by melt kneading. According to another preferred method, the composite is produced by feeding the thermoplastic resin and optionally the additives into an extruder, and supplying the carbon nanotubes to the extruder through a side feeder. This method is effective in suppressing damage to the carbon nanotubes.

As a result of the extrusion, the composite can be produced in the form of pellets.

According to one embodiment, the average length of the carbon nanotubes as raw materials used in the production of the composite may be measured from a scanning electron microscopy (SEM) or transmission electron microscopy (TEM) image. Specifically, a powder of the carbon nanotubes as raw materials is imaged by SEM or TEM, and then the image is analyzed using an image analyzer, for example, Scandium 5.1 (Olympus soft Imaging Solutions GmbH, Germany) to determine the average length of the carbon nanotubes.

The average length and distribution state of the carbon nanotubes included in the composite can be determined by dispersing the resin solid in an organic solvent, for example, acetone, ethanol, n-hexane, chloroform, p-xylene, 1-butanol, petroleum ether, 1,2,4-trichlorobenzene or dodecane, to obtain a dispersion having a predetermined concentration, taking an image of the dispersion by SEM or TEM, and analyzing the image using an image analyzer.

The carbon nanotubes-thermoplastic resin composite produced by the method is free from problems associated with production processing and secondary processability without losing its mechanical strength. In addition, the composite has sufficient electrical properties despite the presence of a small amount of the carbon nanotubes.

According to one embodiment, the composite may be molded into various articles by any suitable process known in the art, such as injection molding, blow molding, press molding or spinning. The molded articles may be injection molded articles, extrusion molded articles, blow molded articles, films, sheets, and fibers.

The films may be manufactured by known melt film-forming processes. For example, according to a single- or twin-screw stretching process, the raw materials are melted in a single- or twin-screw extruder, extruded from a film die, and cooled down on a cooling drum to manufacture an unstretched film. The unstretched film may be appropriately stretched in the longitudinal and transverse directions using a roller type longitudinal stretching machine and a transverse stretching machine called a tenter.

The fibers include various fibers such as undrawn yarns, drawn yarns, and ultra-drawn yarns. The fibers may be manufactured by known melt spinning processes. For example, chips made of the resin composition as a raw material are supplied to and kneaded in a single- or twin-screw extruder, extruded from a spinneret through a polymer flow line switcher and a filtration layer located at the tip of the extruder, cooled down, stretched, and thermoset.

Particularly, the composite of the present invention may be processed into molded articles such as antistatic articles, electrical/electronic product housings, and electrical/electronic parts, taking advantage of its high conductivity.

According to one embodiment, the molded articles may be used in various applications, including automotive parts, electrical/electronic parts, and construction components. Specific applications of the molded articles include: automobile underhood parts, such as air flow meters, air pumps, automatic thermostat housings, engine mounts, ignition bobbins, ignition cases, clutch bobbins, sensor housings, idle speed control valves, vacuum switching valves, ECU housings, vacuum pump cases, inhibitor switches, revolution sensors, acceleration sensors, distributor caps, coil bases, ABS actuator cases, radiator tank tops and bottoms, cooling fans, fan shrouds, engine covers, cylinder head covers, oil caps, oil pans, oil filters, fuel caps, fuel strainers, distributor caps, vapor canister housings, air cleaner housings, timing belt covers, brake booster parts, various cases, various tubes, various tanks, various hoses, various clips, various valves, and various pipes; automobile interior parts, such as torque control levers, safety belt parts, register blades, washer levers, window regulator handles, window regulator handle knobs, passing light levers, sun visor brackets, and various motor housings, automobile exterior parts, such as roof rails, fenders, garnishes, bumpers, door mirror stays, spoilers, hood louvers, wheel covers, wheel caps, grill apron cover frames, lamp reflectors, lamp bezels, and door handles; various automobile connectors, such as wire harness connectors, SMJ connectors, PCB connectors, and door grommet connectors; and electric/electronic parts, such as relay cases, coil bobbins, optical pickup chassis, motor cases, notebook PC housings and internal parts, LED display housings and internal parts, printer housings and internal parts, housings and internal parts of portable terminals such as cell phones, mobile PCs, and portable mobiles, recording medium (e.g., CD, DVD, PD, and FDD) drive housings and internal parts, copier housings and internal parts, facsimile housings and internal parts, and parabolic antennas.

Further applications include household and office electric appliance parts, for example, VTR parts, television parts, irons, hair dryers, rice boiler parts, microwave oven parts, acoustic parts, parts of imaging devices such as video cameras and projectors, substrates of optical recording media such as Laserdiscs (registered trademark), compact discs (CD), CD-ROM, CD-R, CD-RW, DVD-ROM, DVD-R, DVD-RW, DVD-RAM and Blu-ray discs, illuminator parts, refrigerator parts, air conditioner parts, typewriter parts, and word processor parts.

Other applications include: housings and internal parts of electronic musical instruments, household game machines, and portable game machines; electric/electronic parts, such as various gears, various cases, sensors, LEP lamps, connectors, sockets, resistors, relay cases, switches, coil bobbins, capacitors, variable capacitor cases, optical pickups, oscillators, various terminal boards, transformers, plugs, printed circuit boards, tuners, speakers, microphones, headphones, small motors, magnetic head bases, power modules, semiconductor parts, liquid crystal parts, FDD carriages, FDD chassis, motor brush holders, transformer members, and coil bobbins; and various automobile connectors, such as wire harness connectors, SMJ connectors, PCB connectors, and door grommet connectors.

The molded article can be used as an electromagnetic shielding material because it has improved conductivity sufficient to absorb electromagnetic waves. The electromagnetic shielding material exhibits improved electromagnetic wave absorptivity because it has the ability to absorb and decay electromagnetic waves.

The thermoplastic resin composite and the molded article composed of the composite can be recycled, for example, by grinding the composite and the molded article, preferably into a powder, and optionally blending with additives to obtain a resin composition. The resin composition can be processed into the composite of the present invention and can also be molded into the molded article of the present invention.

The present invention will be explained in detail with reference to the following examples. The invention may, however, be embodied in many different forms and should not be construed as being limited to these examples. The examples are provided to fully convey the invention to a person having ordinary knowledge in the art.

EXAMPLES

Components and an additive used in the following examples and comparative examples are as follows.

(a) Polyamide resin
LUMID GP-1000B (LG Chem Ltd.)

(b) Carbon nanotubes
Carbon nanotubes having different $I_D/I_G$ ratios, shapes, average diameters, and average lengths shown in Table 1 were purchased and used.

(c) Carbonaceous conductive additive
Carbon black was purchased and used as a carbonaceous conductive additive. The carbon black had a conductivity of about $10^7$ $\Omega$/sq when it was included in an amount of about 8 wt% in a polycarbonate resin. The carbon black can be appropriately selected by those skilled in the art.

Examples 1-4 and Comparative Examples 1-3

3 wt% of the carbon nanotubes, 1 wt% of the carbonaceous conductive additive, and 96 wt% of the polyamide resin (LUMID GP-1000B) were mixed together. The mixture was extruded in a twin-screw extruder (L/D = 42, $\phi$ = 40 mm) at 280 °C to produce pellets having dimensions of 0.2 mm $\times$ 0.3 mm $\times$ 0.4 mm.
The pellets were molded in an injection molding machine under flat profile conditions at a temperature of 280 °C to produce 3.2 mm thick, 12.7 mm long dogbone shaped specimens. The specimen was allowed to stand at 23 °C and RH 50% for 48 hr.

[TABLE 1]

| Specifications | | Example No. | | | | Comparative Example No. | | |
|---|---|---|---|---|---|---|---|---|
| | | 1 | 2 | 3 | 4 | 1 | 2 | 3 |
| | Type | Bundle | Bundle | Bundle | Bundle | Bundle | Bundle | Bundle |
| | Length of carbon nanotubes before processing (nm) | 1455 | 1285 | 1825 | 2845 | 1170 | 1565 | 725 |
| MWNTs | $I_D/I_G$ | 0.56 | 0.69 | 0.82 | 0.88 | 0.91 | 1.11 | 1.05 |
| | Ratio of residual length (%) | 71 | 67 | 56 | 52 | 55 | 35 | 46 |
| | Residual length of carbon nanotubes after processing (nm) | 1033 | 861 | 1022 | 1479 | 643 | 548 | 334 |

The average length of the bundle type carbon nanotubes as raw materials before processing was measured by dispersing the powdered carbon nanotubes in a solution by sonication for a time of 30 sec to 2 min, imaging the dispersion on a wafer by SEM, and analyzing the SEM images using Scandium 5.1 (Olympus soft Imaging Solutions GmbH, Germany).

**EXPERIMENTAL EXAMPLES**

The physical properties of the specimens produced in Examples 1-4 and Comparative Examples 1-3 were measured by the following methods. The results are shown in Table 2.

- Tensile strength and tensile modulus

The 3.2 mm thick specimens were evaluated for tensile strength and tensile modulus in accordance with the ASTM D638 testing standard.

- Surface resistivity (Ω/sq)

The surface resistance values of the specimens were measured using SRM-100 (PINION) in accordance with ASTM D257.

- Average length of residual carbon nanotubes

The pellets were dispersed in chloroform to obtain 0.1 g/l dispersions. Images of the dispersions were taken by TEM (Libra 120, Carl Zeiss Gmbh, Germany) and analyzed using SCANDIUM 5.1 (Olympus Soft Imaging Solutions GmbH) to determine the average lengths of the residual carbon nanotubes.

[TABLE 2]

| | | Example No. | | | | Comparative Example No. | | |
|---|---|---|---|---|---|---|---|---|
| | | 1 | 2 | 3 | 4 | 1 | 2 | 3 |
| Physical properties | Tensile strength (MPa) | 87 | 85 | 86 | 94 | 76 | 80 | 80 |
| | Tensile modulus (GPa) | 3.9 | 3.6 | 3.6 | 4.1 | 3.1 | 3.3 | 3.3 |
| | Surface resistivity (Ω/sq) | $1.0 \times 10^6$ | $10 \times 10^7$ | $1.0 \times 10^7$ | $1.0 \times 10^6$ | $1.0 \times 10^{13}$ 1. | $0 \times 10^9$ | $1.0 \times 10^{10}$ |

As shown in Table 2, the molded articles manufactured in Examples 1-4 showed improved electrical conductivity while possessing high tensile strength and tensile modulus values.

## Claims

1. A composite produced by processing a resin composition comprising a thermoplastic resin, bundle type carbon nanotubes, and a carbonaceous conductive additive wherein the carbon nanotubes have an $I_D/I_G$ of 1.0 or less, the $I_D/I_G$ being the ratio of the intensity of D-band peak to that of G-band peak in the Raman spectrum of the carbon nanotubes before the processing, and the ratio of residual length of the carbon nanotubes present in the composite is from 40% to 99%, the ratio of residual length being defined by Equation 1:

$$\text{Ratio of residual length (\%)} = (\text{Average length of the carbon nanotubes present in the composite after processing/Average length of the carbon nanotubes before processing}) \times 100 \qquad (1)$$

2. The composite according to claim 1, wherein the $I_D/I_G$ is from 0.01 to 0.99.

3. The composite according to claim 1, wherein the processing is extrusion.

4. The composite according to claim 1, wherein the ratio of residual length is from 40% to 90%.

5. The composite according to claim 1, wherein the carbon nanotubes comprise a plurality of carbon nanotube strands.

6. The composite according to claim 5, wherein the carbon nanotube strands are from 5 nm to 25 nm in average diameter.

7. The composite according to claim 1, wherein the average length of the carbon nanotubes before the processing is from 1 μm to 1000 μm.

8. The composite according to claim 1, wherein the carbon nanotubes present in the composite have an average length of 400 nm to 100 μm.

9. The composite according to claim 1, wherein the carbon nanotubes present in the composite have an average length of 500 nm to 30,000 nm.

10. The composite according to claim 1, wherein the carbon nanotubes present in the composite have an average length of 500 nm to 5,000 nm.

11. The composite according to claim 1, wherein the carbon nanotubes are used in an amount of 0.1 to 10 parts by weight, based on 100 parts by weight of the thermoplastic resin.

12. The composite according to claim 1, further comprising 0.1 to 10 parts by weight of one or more additives selected from the group consisting of flame retardants, impact modifiers, flame retardant aids, lubricants, plasticizers, heat stabilizers, anti-drip agents, antioxidants, compatibilizers, light stabilizers, pigments, dyes, and inorganic additives, based on 100 parts by weight of the thermoplastic resin.

13. The composite according to claim 1, wherein the thermoplastic resin is selected from the group consisting of: polycarbonate resins; polypropylene resins; polyamide resins; aramid resins; aromatic polyester resins; polyolefin resins; polyester carbonate resins; polyphenylene ether resins; polyphenylene sulfide resins; polysulfone resins; polyethersulfone resins; polyarylene resins; cycloolefin resins; polyetherimide resins; polyacetal resins; polyvinyl acetal resins; polyketone resins; polyether ketone resins; polyether ether ketone resins; polyaryl ketone resins; polyether nitrile resins; liquid crystal resins; polybenzimidazole resins; polyparabanic acid resins; vinyl polymer and copolymer resins obtained by polymerization or copolymerization of one or more vinyl monomers selected from the group consisting of aromatic alkenyl compounds, methacrylic esters, acrylic esters, and vinyl cyanide compounds; diene-aromatic alkenyl compound copolymer resins; vinyl cyanide-diene-aromatic alkenyl compound copolymer resins; aromatic alkenyl compound-diene-vinyl cyanide-N-phenylmaleimide copolymer resins; vinyl cyanide-(ethylene-diene-propylene (EPDM))-aromatic alkenyl compound copolymer resins; polyolefins; vinyl chloride resins; chlorinated vinyl chloride resins; and mixtures thereof.

14. The composite according to claim 1, wherein the carbonaceous conductive additive is selected from carbon black, graphene, fullerenes, carbon nanofibers, and mixtures thereof.

15. The composite according to claim 14, wherein the carbon black is selected from furnace black, channel black, acetylene black, lamp black, thermal black, ketjen black, and mixtures thereof.

16. The composite according to claim 1, wherein the carbonaceous conductive additive is present in an amount of 0.1 to 10 parts by weight, based on 100 parts by weight of the thermoplastic resin.

17. A molded article comprising the composite according to any one of claims 1 to 16.

18. A molded article manufactured by processing the composite according to any one of claims 1 to 16.

19. The molded article according to claim 18, wherein the processing is extrusion, injection molding or a combination thereof.

20. The molded article according to claim 18, wherein the carbon nanotubes present in the molded article after processing have an average length of 0.5 to 30 $\mu$m.

21. The molded article according to claim 18, wherein the molded article is an antistatic article, an electrical/electronic product housing or an electrical/electronic part.

## INTERNATIONAL SEARCH REPORT

| International application No. |
| --- |
| **PCT/KR2014/011814** |

### A. CLASSIFICATION OF SUBJECT MATTER

***H01B 1/24(2006.01)i, H01B 1/04(2006.01)i, H05K 9/00(2006.01)i***

According to International Patent Classification (IPC) or to both national classification and IPC

### B. FIELDS SEARCHED

Minimum documentation searched (classification system followed by classification symbols)
H01B 1/24; C08K 7/00; C08J 3/20; C08L 101/00; C08L 77/00; C08K 7/24; C08K 3/04; B82Y 30/00; H01B 1/04; H05K 9/00

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: resin, carbon nano tube, composite, processing process, persistence rate of length

### C. DOCUMENTS CONSIDERED TO BE RELEVANT

| Category* | Citation of document, with indication, where appropriate, of the relevant passages | Relevant to claim No. |
| --- | --- | --- |
| A | KR 10-0900658 B1 (LG CHEM, LTD.) 01 June 2009<br>See abstract; paragraphs [0004]-[0009], [0027]; claims 1-14. | 1-21 |
| A | KR 10-2006-0060682 A (GENERAL ELECTRIC COMPANY) 05 June 2006<br>See abstract; claims 1-13. | 1-21 |
| A | JP 2006-257242 A (IDEMITSU KOSAN CO LTD) 28 September 2006<br>See abstract; claims 1-5. | 1-21 |
| A | KR 10-2008-0042086 A (AGENCY FOR SCIENCE, TECHNOLOGY AND RESEARCH)<br>14 May 2008<br>See abstract; claims 1-12. | 1-21 |
| A | JP 2004-143240 A (ASAHI KASEI CHEMICALS CORP) 20 May 2004<br>See abstract; claims 1-14. | 1-21 |
| A | US 2005-0070657 A1 (ELKOVITCH et al.) 31 March 2005<br>See abstract; claims 1-19. | 1-21 |

☐ Further documents are listed in the continuation of Box C.   ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 04 MARCH 2015 (04.03.2015) | **04 MARCH 2015 (04.03.2015)** |

| Name and mailing address of the ISA/KR<br>Korean Intellectual Property Office<br>Government Complex-Daejeon, 189 Seonsa-ro, Daejeon 302-701,<br>Republic of Korea<br>Facsimile No. 82-42-472-7140 | Authorized officer<br><br>Telephone No. |
| --- | --- |

Form PCT/ISA/210 (second sheet) (July 2009)

INTERNATIONAL SEARCH REPORT
Information on patent family members

International application No.

**PCT/KR2014/011814**

| Patent document cited in search report | Publication date | Patent family member | Publication date |
|---|---|---|---|
| KR 10-0900658 B1 | 01/06/2009 | NONE | |
| KR 10-2006-0060682 A | 05/06/2006 | EP 1631970 A1 | 08/03/2006 |
| | | EP 1654740 A1 | 10/05/2006 |
| | | JP 2006-526058 A | 16/11/2006 |
| | | JP 2007-512658 A | 17/05/2007 |
| | | KR 10-2006-0008928 A | 27/01/2006 |
| | | US 2004-0211942 A1 | 28/10/2004 |
| | | US 2005-0029498 A1 | 10/02/2005 |
| | | WO 2004-097852 A1 | 11/11/2004 |
| | | WO 2005-015574 A1 | 17/02/2005 |
| JP 2006-257242 A | 28/09/2006 | CN 101142284 B | 05/09/2012 |
| | | DE 112006000571 T5 | 24/01/2008 |
| | | JP 04783041 B2 | 28/09/2011 |
| | | US 2009-0076195 A1 | 19/03/2009 |
| | | US 7981959 B2 | 19/07/2011 |
| | | WO 2006-098283 A1 | 21/09/2006 |
| KR 10-2008-0042086 A | 14/05/2008 | EP 1904568 A1 | 02/04/2008 |
| | | JP 05236468 B2 | 17/07/2013 |
| | | JP 2009-501834 A | 22/01/2009 |
| | | US 2009-0127516 A1 | 21/05/2009 |
| | | US 8114314 B2 | 14/02/2012 |
| | | WO 2007-011313 A1 | 25/01/2007 |
| JP 2004-143240 A | 20/05/2004 | JP 4162466 B2 | 08/10/2008 |
| US 2005-0070657 A1 | 31/03/2005 | CN 1886808 A | 27/12/2006 |
| | | EP 1671335 A1 | 21/06/2006 |
| | | JP 2007-507562 A | 29/03/2007 |
| | | KR 10-2006-0120023 A | 24/11/2006 |
| | | US 7309727 B2 | 18/12/2007 |
| | | WO 2005-034144 A1 | 14/04/2005 |

Form PCT/ISA/210 (patent family annex) (July 2009)